# FASCICULE DE BREVET EUROPEEN

(11) **EP 0 367 657 B1**
(45) Date de publication et mention de la délivrance du brevet: **29.12.1993**
(21) Numéro de dépôt: 89402923.0
(22) Date de dépôt: 24.10.1989
(51) Int. Cl.: H03C 7/02, H04L 27/20

(54) **Déphaseur hyperfréquence à déphasage O ou TT**
Mikrowellen-Phasenschieber mit O- oder Pi-Phasenverschiebung
Microwave phase shifter with omicron or pi phase shift

(30) Priorité: 28.10.1988 FR 8814135
(43) Date de publication de la demande: 09.05.1990
(73) Titulaire: THOMSON-CSF, 75008 Paris (FR)
(72) Inventeur: Baril, Michel, F-92045 Paris la Défense (FR); Rimbert, Dominique, F-92045 Paris la Défense (FR)
(74) Mandataire: Beylot, Jacques

(56) Documents cités:
- EP-A- 0 221 632
- DE-A- 2 719 272
- US-A- 3 829 797
- PATENT ABSTRACTS OF JAPAN, vol. 11, no. 110 (E-496)[2257], 7 avril 1987; & JP-A-61 257 050 (HITACHI SHONAN DENSHI K.K.) 14-11-1986
- 9TH EUROPEAN MICROWAVE CONFERENCE, Brighton, 17-20 septembre 1979, pages 311-315, Microwave Exhibitions & Publishers Ltd, Sevenoaks, Kent, GB; W.C. TSAI et al.: "Switching & frequency conversion using dual-gate FETs"

## Description

La présente invention se rapporte à un déphaseur hyperfréquence apte à engendrer, en réponse à un signal de commande, un déphasage soit sensiblement égal à zéro, soit sensiblement égal à π.

Il est connu d'utiliser des déphaseurs 0/π , par exemple dans les dispositifs de modulation par codage de phase 0/π ou dans les déphaseurs électroniques quantifiés utilisés pour chaque module d'antenne radar à balayage électronique.

Plusieurs sortes de dispositifs permettant la réalisation de déphaseurs 0/π, soit pour un modulateur de phase soit comme bit élémentaire dans un déphaseur électronique pour antenne à balayage, ont été proposés à ce jour, dont :
- Des déphaseurs utilisant une diode PIN placée à l'extrémité d'une ligne de transmission normalement ouverte : la diode PIN a pour rôle de court-circuiter cette ligne, en créant ainsi une variation de déphasage égale à π. Ce déphaseur utilise nécessairement un circulateur en bout de ligne, un tel circulateur étant plutot encombrant. En outre, ce type de déphaseur a des performances limitées, en raison en particulier de la capacité parasite de la diode qui intervient de façon préjudiciable sur sa largeur de bande.
- Des déphaseurs utilisant deux diodes PIN placées à l'extrémité des bras de sortie d'un coupleur hybride 3 dB. Ce coupleur hybride est lui-aussi trop encombrant, de sorte que ce dispositif présente les mêmes inconvénients que le précédent.
- Des déphaseurs à perturbations constitués par la mise en cascade de cellules à faible déphasage utilisant des paires de diodes PIN pour charger une ligne de transmission. Il s'agit d'un dispositif qui est alternativement commuté d'un type de filtre passe-haut à un type de filtre passe-bas, par modification de l'état des diodes. Ce genre de déphaseur peut être très encombrant si l'on désire qu'il fonctionne à large bande, du fait que sa largeur de bande ne peut être augmentée qu'en augmentant corrélativement le nombre de cellules.
- Des déphaseurs à commutation de lignes dans lesquels deux paires de diodes PIN placées dans des jonctions en Té assurent le passage de l'onde dans une voie ou l'autre du système, l'écart de longueur des voies étant égal à une demi-longueur d'onde à la fréquence de fonctionnement. Ce type de déphaseur a lui aussi pour inconvénients d'être encombrant et de largeur de bande limitée.

Des déphaseurs à inversion, tels que décrits dans le document FR-A-2.379.196, dans lesquels une ligne de transmission de type microstrip par exemple est couplée à une ligne à fente à l'aide de deux diodes PIN dont les états de fonctionnement sont opposés : il s'ensuit, suivant l'état des diodes, une excitation de la ligne à fente avec des phases dont l'écart est intrinsèquement égal à π. Ce dispositif a pour inconvénient d'être limité, en valeur de la largeur de bande, à un pourcentage d'environ
30 % de la fréquence porteuse. Il n'est en outre pratiquement pas réalisable en circuit intégré, et reste finalement assez encombrant.

On connaît également par le document EP-A- 0221 632 un modulateur pouvant fonctionner en hyperfréquence utilisant un transistor à effet de champ dont les électrodes grille, drain et source sont flottantes par rapport à la masse, et un balun connecté par ses entrées symétriques aux électrodes drain et source du transistor à effet de champ. La présence du balun réalisé en hyperfréquence à l'aide d'un té magique constitue un élément encombrant qui s'oppose à l'utilisation en grand nombre de ce type de modulateur pour réaliser des déphaseurs hyperfréquences 0 ou π dans des antennes radar à balayage électronique.

L'invention vise à remédier à ces inconvénients. Elle se rapporte à cet effet à un déphaseur 0/π à transistor à effet de champ avec trois électrodes : une grille, un drain et une source, apte à engendrer à partir d'une onde hyperfréquence d'entrée, appliquée entre sa grille et la masse une onde hyperfréquence de sortie avec un déphasage soit sensiblement nul, soit sensiblement égal à π en réponse à un signal de commande, dans lequel l'onde hyperfréquence de sortie est extraite entre l'une des électrode drain ou source et la masse et qui est équipé de moyens de commutation en basse fréquence pour appliquer entre les deux électrodes source et drain, une tension continue de polarisation d'une valeur déterminée, mais de signe différent selon la valeur du déphasage souhaitée, soit zero, soit π.

Avantageusement, la source et le drain du transistor à effet de champ sont alimentés au travers d'un commutateur électronique à transistors de commutation en basse-fréquence qui sont aptes à fonctionner sous la même tension continue que le transistor à effet de champ.

De toute façon, l'invention sera bien comprise, et ses avantages et autres caractéristiques ressortiront, au cours de la description suivante d'un exemple non limitatif de réalisation, en référence au dessin annexé dans lequel :
- Figure 1 est un schéma de principe de ce déphaseur hyperfréquence 0/π; et
- Figure 2 est un schéma électrique plus détaillé de ce même déphaseur hyperfréquence.

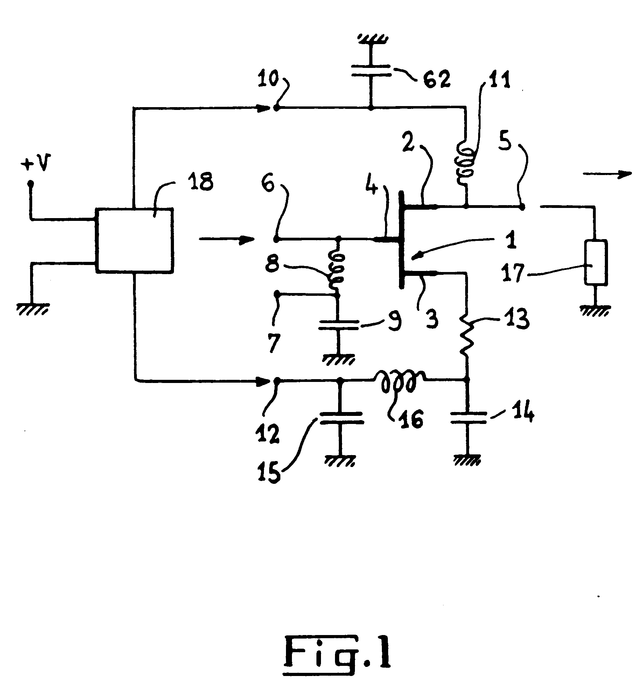

Sur la figure 1, la référence 1 désigne un transistor à effet de champ (ou FET) à l'Arséniure de Gallium. Ce transistor FET est avantageusement choisi du type N, la mobilité des électrons étant supérieure à celle des trous. Il est en outre avantageusement choisi pour être pratiquement symétrique. Un tel transistor FET, de par la symétrie qu'il présente entre son drain et sa source, a la propriété de voir sa structure retournée si l'on inverse des tensions appliquées à ces deux électrodes, l'électrode 2, initialement le drain, devenant la source et l'électrode 3, initialement la source, devenant le drain. Il s'ensuit, si le transistor FET 1 est monté en amplificateur hyperfréquence, qu'une borne de sortie hyperfréquence 5 placée sur l'une des électrodes, en l'occurence sur l'électrode 2, voit lors de l'inversion précitée des polarisations, son signal changé de signe, ce qui revient à un déphasage de π du signal de sortie en 5 par rapport au signal huperfréquence d'entrée appliqué en 6 sur la grille 4 du transistor FET 1.

Sur le circuit de principe, très dépouillé, de la figure 1, la polarisation continue négative de la grille 4 est appliquée sur la borne 7 à travers un filtre hyperfréquence composé d'une self de choc 8 et d'une capacité de découplage 9. L'électrode 2 reçoit sa polarisation sur la borne 10, à travers un autre filtre hyperfréquence composé d'une self de choc 11 et d'une capacité de découplage 62. L'électrode 3 reçoit, quant à elle, sa polarisation sur la borne 12 à travers la résistance de polarisation continue 13 qui est découplée par une capacité 14. De même que précédemment, cette polarisation est appliquée à travers un filtre composé d'une capacité de découplage 15 et d'une self de choc 16. Il est en outre représenté en 17 l'impédance de charge du circuit d' utilisation.

Conformément à l'invention, des moyens de commutation, illustrés schématiquement par un inverseur bipolaire 18, permettent d'appliquer, selon la position de cet inverseur, soit la tension continue d'alimentation + V sur la borne 10 et la masse sur la borne 12, soit l'inverse, c'est à dire la masse sur la borne 10 et la tension continue + V sur la borne 12. Le transistor FET étant symétrique, cette inversion des polarisations entre source et drain entraine une inversion du sens du courant dans le semi-conducteur qui constitue le canal de ce transistor, de sorte que, comme expliqué ci-dessus, le signal hyperfréquence pris sur la sortie 5 est déphasé de π. Ce circuit procure donc le déphasage 0/π souhaité sans utiliser d'éléments de commutation en hyperfréquence, mais simplement des moyens de commutation de tension continue, qui sont des éléments de commutation basse-fréquence.

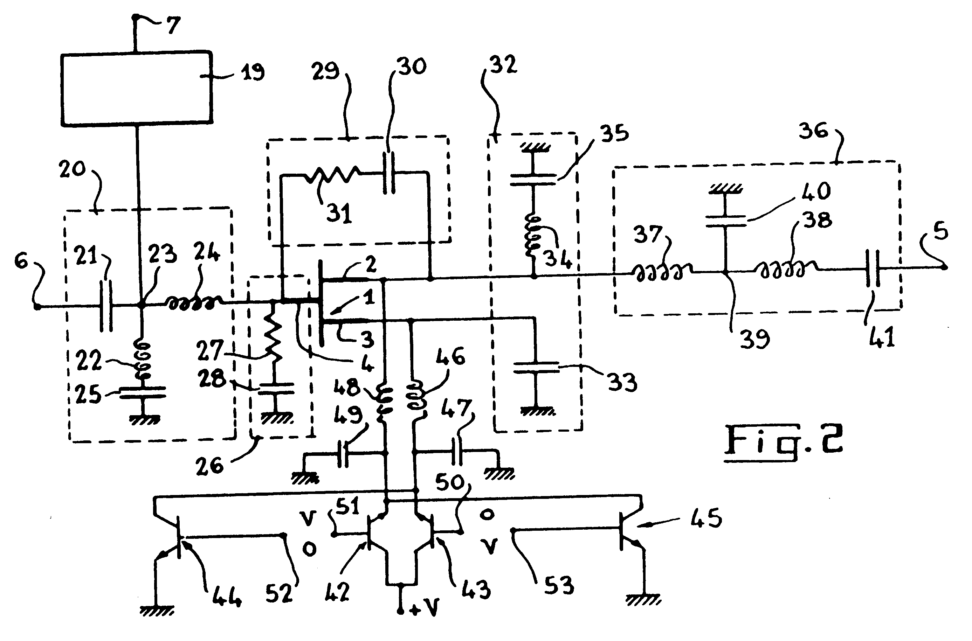

Un schéma plus pratique de réalisation du circuit de principe de la figure 1 est donné, à titre d'exemple, à la figure 2.

On reconnait sur ce schéma le transistor FET 1, avec son électrode 3, sa grille 4, et son autre électrode 2.

La grille 4 est alimentée en polarisation continue à partir de la borne 7 précitée et à travers un circuit de polarisation de grille classique 19 comportant une self de choc et une capacité de découplage (non représentés).

Le signal hyperfréquence est appliqué sur la borne d'entrée 6 précitée à la grille 4, à travers un circuit d'adaptation d'entrée 20 qui comporte une capacité de liaison 21, un élément inductif parallèle 22 branché entre la sortie 23 du circuit de polarisation 19 et la masse, avec capacité 25 d'arrêt pour le courant continu, et un élément inductif série 24 branché entre le point 23 et la grille 4.

Avantageusement en outre, il est prévu un circuit 26 de compensation d'amplitude parallèle sur la grille 4. Ce circuit 26 est composé d'une résistance 27 en série avec une capacité de découplage 28. Il a pour but de rendre proches les gains ou les pertes du déphaseur dans les deux états, et d'améliorer le rapport d'ondes stationnaires (R.O.S.) d'entrée du déphaseur.

Un circuit de contre-réaction série 29, comportant une capacité 30 et une résistance 31 en série, est inséré entre l'électrode 2 et la grille 4. Il pour but de stabiliser le transistor FET et de rendre la différence de phase selon les deux états constante dans une bande de fréquence d'au moins une octave en bande S en prenant une capacité de l'ordre de 1 picofarad. Cette contre-réaction série permet en outre de rendre proches les gains ou les pertes du déphaseur dans les deux états et d'améliorer son rapport d'ondes stationnaires d'entrée.

Il est en outre prévu un circuit de compensation de phase 32, constitué d'une capacité 33 mise en parallèle entre l'électrode 3 et la masse et d'une self parallèle 34 avec capacité de découplage 35 sur l'électrode 2, ainsi qu'un circuit d'adaptation de sortie 36. Ce circuit 36 comporte deux selfs en série 37, 38 dont le point de jonction 39 est découplé à la masse par une capacité 40, et il inclut une capacité de liaison 41, le signal hyperfréquence de sortie étant pris sur la borne 5 précitée.

Les moyens de commutation précités, aptes à appliquer soit la polarisation + V volts sur le drain 2 et la polarisation 0 volts sur la source 3, soit à l'inverse cette même polarisation + V volts sur la source 3 et la polarisation 0 volts sur le drain 2, comportent quatre transistors identiques NPN de commutation en relativement basse-fréquence 42, 43, 44, 45, qui polarisent les électrodes 2 et 3, chacune par l'intermédiaire d'une self de choc et d'une capacité de découplage hyperfréquence, respectivement 46, 47 et 48, 49.

Les deux transistors 43, 42 ont chacun leur collecteur relié à la source d'alimentation continue + V, qui est par exemple de l'ordre de 5 à 6 volts et est par suite aussi bien apte à alimenter les transistors de commutation 42 à 45 que le transistor FET 1. Leurs émetteurs sont respectivement reliés aux électrodes 2 et 3 par l'intermédiaire des filtres hyperfréquence précités 46, 47 et 48, 49.

Sur leurs électrodes de base respectives 50, 51 est appliquée une tension continue de commande 0 volts ou + V volts qui est fournie, par des moyens classiques de commutation logique non représentés (constitués par exemple par les deux sorties d'une bascule listable fonctionnant en diviseur par deux), de façon inverse à chacune des bases respectives 50, 51 : lorsque la tension 0 volts est appliquée à l'électrode 51, la tension + V volts est simultanément appliquée à l'électrode 50, et vice-versa.

Le transistor 44 a son émetteur connecté à la masse, tandis que son collecteur est relié à l'émetteur du transistor 43. Sa base est alimentée en 52 par la même tension de commande, 0 volts ou + V volts, que la base 51 du transistor 42. De même, le transistor 45 a son émetteur relié à la masse, tandis que son collecteur est relié à l'émetteur du transistor 42 et que sa base est alimentée en 53 par la même tension de commande, + V volts ou 0 volts, que la base 50 du transistor 43.

Le fonctionnement de ce circuit est le suivant :
Supposons tout d'abord que les tensions de commande continue appliquées aux bornes 51, 52 d'une part et 50, 53 d'autre part soient respectivement égales à + V volts et 0 volts, comme indiqué sur la figure 2. Il s'ensuit que les transistors 42 et 44 sont saturés, tandis que les transistors 43 et 45 sont bloqués. L'électrode 2 du transistor FET 1 est pratiquement portée à la tension + V volts, tandis que sa source 3 est pratiquement reliée à la masse. Le signal hyperfréquence appliqué en 6 se retrouve donc en 5 normalement amplifié conformément au gain du transistor 1 qui est normalement égal à 1. Si maintenant les tensions de commande sont inversées, les tensions aux bornes 51, 52 d'une part, et 50, 53 d'autre part, sont respectivement égales à 0 volts et + V volts. Par suite, les transistors 43 et 45 sont saturés tandis que les transistors 42 et 44 sont bloqués. C'est cette fois-ci l'électrode 3 qui est pratiquement portée à la tension d'alimentation continue + V volts, tandis que l'électrode 2 est pratiquement reliée à la masse : comme expliqué précédemment, le transistor FET 1 est inversé de sorte que le signal hyperfréquence de sortie apparaissant en 5 est déphasé de π par rapport au signal de sortie précédent.

Bien entendu, le déphasage de π précité et obtenu avec le circuit de la figure 2 est purement théorique. Il suppose en effet que le transistor FET utilisé est parfaitement symétrique, et il sous-entend que les effets des éléments parasites sont totalement compensés, ce qui n'est pas toujours le cas selon la fréquence utilisée.

Les essais montrent qu'avec un transistor FET seul, choisi le plus symétrique possible, la différence de phase entre les deux états est très proche de 180 degrés (phase d'insertion proche de zéro degré pour l'état de déphasage 0 et proche de 180 degrés pour l'état de déphasage π ) pour des fréquences relativement basses (inférieures à 1 Gigahertz), mais que cette différence diminue lorsque la fréquence augmente, et d'autant plus vite que le développement de la grille unitaire du transistor FET est grand : les éléments parasites du transistor FET voient en effet leurs influences augmentées avec la fréquence et avec le développement de grille unitaire.

Le circuit de compensation de phase 32 diminue avantageusement les effets des éléments parasites. Le circuit de la figure 2 est simple à mettre en oeuvre, utilisant une seule et même tension d'alimentation pour le transistor FET et les transistors de commutation 43 à 45, et ne comportant aucun élément de commutation en hyperfréquence. Il permet d'obtenir un écart de phase de 180 ° ± 2° sur environ 30 % de bande de fréquence en bande S.

Il convient également de faire remarquer que, contrairement à ce qui se passe avec les déphaseurs connus, les pertes peuvent être, avec ce nouveau type de circuit, rendues nulles pour les deux états. Si en effet le transistor FET est choisi pour que ce circuit, qui est en fait un circuit amplificateur, aît un gain rigoureusement égal à un, il s'ensuit que les pertes du déphaseur sont nulles pour chacun des deux états 0 ou π.

Comme il va de soi, l'invention n'est pas limitée à l'exemple de réalisation qui vient d'être décrit. D'autres circuits de compensation pourraient être ajoutés à ceux équipant déjà le dispositif de la figure 2. Des circuits comportant plusieurs transistors FET, fonctionnant par exemple en parallèle, pourraient être utilisés. Le transistor FET pourrait éventuellement ne pas être parfaitement symétrique, et avoir son circuit adapté en conséquence. Au lieu d'être prise sur l'électrode 2 du transistor FET, la sortie hyperfréquence pourrait être prise sur l'électrode 3. Au lieu d'une tension d'alimentation (+ V,0) prise entre une seule borne positive et la masse, une source d'alimentation (+ V, - V) comportant une première borne positive et une seconde borne négative pourrait aussi bien être utilisée. Le matériau constitutif du transistor à effet de champ pourrait être autre que l'Arséniure de Gallium, et son dopage pourrait être du type P au lieu d'être du type N, etc...

## Revendications

1. Déphaseur à transistor à effet de champ (1) avec trois électrodes : une grille (4), un drain et une source apte à engendrer à partir d'une onde hyperfréquence d'entrée appliquée entre sa grille (4) et la masse une onde hyperfréquence de sortie avec un déphasage soit sensiblement nul soit sensiblement égal à π en réponse à un signal de commande caractérisé en ce que ladite onde hyperfréquence de sortie est extraite entre l'une des électrodes drain ou source (2, 3) dite électrode de sortie et la masse pour être appliquée à une impédance de charge (17) connectée entre ladite électrode de sortie et la masse, et en ce qu'il est équipé de moyens de commutation en basse fréquence (18, 42 à 45) pour appliquer entre les deux électrodes drain source (2, 3) une tension continue de polarisation d'une valeur déterminée (V) mais de signe différent selon la valeur de déphasage souhaitée, soit zéro, soit π.

2. Déphaseur hyperfréquence selon la revendication 1, caractérisé en ce que lesdits moyens de commutation en basse fréquence comportent des transistors de commutation (42 à 45) aptes à fonctionner sous la même tension continue d'alimentation que le transistor à effet de champ.

3. Déphaseur hyperfréquence selon la revendication 1, caractérisé en ce que le transistor à effet de champ est un transistor à l'Arséniure de Gallium constitué d'un matériau de type N.

4. Déphaseur hyperfréquence selon la revendication 1, caractérisé en ce qu'il comporte un circuit de compensation de phase (32) comportant sur l'électrode de sortie (2 ou 3) du transistor à effet de champ (1), un circuit à self (24) et capacité (35) en série branché entre cette électrode et la masse, et une capacité de découplage (33) sur l'autre électrode source ou drain (3 ou 2) de ce transistor à effet de champ (1).

5. Déphaseur hyperfréquence selon la revendication 1, caractérisé en ce qu'il comporte un circuit de contre-réaction (29) connecté entre l'électrode de sortie (2) et la grille (4) du transistor à effet de champ.

6. Déphaseur hyperfréquence selon la revendication 1, caractérisé en ce qu'il comporte un circuit de compensation d'amplitude (26) connecté entre la masse et la grille (4) du transistor à effet de champ et constitué d'une résistance (27) en série avec une capacité de découplage (28).

7. Déphaseur hyperfréquence selon la revendication 1, caractérisé en ce qu'il comporte, un circuit d'adaptation de sortie (36) intercalé entre l'électrode de sortie (2 ou 3) du transistor à effet de champ (1) et l'impédance de charge, et constitué de deux selfs en série (37, 38) dont le point de jonction est découplé à la masse par une capacité (40).

## Claims

1. Phase shifter with field-effect transistor (1) with three electrodes: a gate (4), a drain and a source which is capable of generating, from an input microwave applied between its gate (4) and earth, an output microwave with a phase shift which is either substantially zero or substantially equal to π in response to a control signal, characterized in that the said output microwave is extracted between one of the electrodes, drain or source (2, 3), termed the output electrode and earth so as to be applied to a load impedance (17) connected between the said output electrode and earth, and in that it is equipped with low-frequency switching means (18, 42 to 45) for applying between the two electrodes, drain and source (2, 3), a DC bias voltage of a specified value (V) but of different sign depending on the desired value of phase shift, either zero or π.

2. Microwave phase shifter according to Claim 1, characterized in that the said low-frequency switching means include switching transistors (42 to 45) which are capable of operating under the same DC supply voltage as the field-effect transistor.

3. Microwave phase shifter according to Claim 1, characterized in that the field-effect transistor is a gallium arsenide transistor constituted from an N-type material.

4. Microwave phase shifter according to Claim 1, characterized in that it includes a phase compensation circuit (32) including on the output electrode (2 or 3) of the field-effect transistor (1), a circuit with choke (24) and capacitor (35) in series which is wired between this electrode and earth, and a decoupling capacitor (33) on the other electrode, source or drain (3 or 2), of this field-effect transistor (1).

5. Microwave phase shifter according to Claim 1, characterized in that it includes a feedback circuit (29) connected between the output electrode (2) and the gate (4) of the field-effect transistor.

6. Microwave phase shifter according to Claim 1, characterized in that it includes an amplitude compensation circuit (26) connected between earth and the gate (4) of the field-effect transistor and constituted from a resistor (27) in series with a decoupling capacitor (28).

7. Microwave phase shifter according to Claim 1, characterized in that it includes an output matching circuit (36) interposed between the output electrode (2 or 3) of the field-effect transistor (1) and the load impedance, and constituted from two chokes in series (37, 38) whose junction point is decoupled from earth by a capacitor (40).

## Patentansprüche

1. Phasenschieber mit Feldeffekttransistor (1), der drei Elektroden, nämlich ein Gate (4), einen Drain und eine Source besitzt und ausgehend von einer zwischen Gate (4) und Masse angelegten Eingangsmikrowelle eine Ausgangsmikrowelle erzeugen kann, deren Phasenverschiebung abhängig von einem Steuersignal entweder im wesentlichen null oder im wesentlichen gleich π ist, dadurch gekennzeichnet, daß die Ausgangsmikrowelle zwischen einer der Elektroden Drain und Source (2, 3), Ausgangselektrode genannt, und Masse entnommen wird, um an eine zwischen dieser Ausgangselektrode und Masse angeschlossene Lastimpedanz (17) angelegt zu werden, und daß der Phasenschieber Niederfrequenzschaltmittel (18, 42 bis 45) besitzt, um zwischen die Drain- und Source-Elektrode (2, 3) eine Gleichvorspannung eines bestimmten Werts (V) anzulegen, deren Vorzeichen je nach dem Wert 0 oder π der gewünschten Phasenverschiebung unterschiedlich ist.

2. Mikrowellen-Phasenschieber nach Anspruch 1, dadurch gekennzeichnet, daß die Niederfrequenzschaltmittel Schalttransistoren (42 bis 45) enthalten, die mit der gleichen Speisegleichspannung wie der Feldeffekttransistor betrieben werden können.

3. Mikrowellen-Phasenschieber nach Anspruch 1, dadurch gekennzeichnet, daß der Feldeffekttransistor ein Galliumarsenid--Transistor ist, der aus einem Material vom Typ N besteht.

4. Mikrowellen-Phasenschieber nach Anspruch 1, dadurch gekennzeichnet, daß er einen Phasenkompensationskreis (32) enthält, der an der Ausgangselektrode (2 oder 3) des Feldeffekttransistors (1) eine Schaltung mit einer Spule (24) und einem Kondensator (35) in Serie zwischen dieser Elektrode und Masse und einen Entkopplungskondensator (33) an der anderen Elektrode, nämlich der Source- oder Drain-Elektrode (3 oder 2), dieses Feldeffekttransistors (1) enthält.

5. Mikrowellen-Phasenschieber nach Anspruch 1, dadurch gekennzeichnet, daß er einen Gegenkopplungskreis (29) enthält, der zwischen die Ausgangselektrode (2) und das Gate (4) des Feldeffekttransistors eingefügt ist.

6. Mikrowellen-Phasenschieber nach Anspruch 1, dadurch gekennzeichnet, daß er einen Amplitudenkompensationskreis (26) enthält, der zwischen Masse und das Gate (4) des Feldeffekttransistors eingefügt ist und aus einem Widerstand (27) in Reihe mit einem Entkopplungskondensator (28) besteht.

7. Mikrowellen-Phasenschieber nach Anspruch 1, dadurch gekennzeichnet, daß er einen Ausgangsanpassungskreis (36) besitzt, der zwischen die Ausgangselektrode (2 oder 3) des Feldeffekttransistors (1) und die Lastimpedanz eingefügt ist und aus zwei Spulen (37, 38) in Reihe besteht, deren Verbindungspunkt gegen Masse durch einen Kondensator (40) entkoppelt ist.
